# EUROPÄISCHE PATENTSCHRIFT

(11) **EP 0 841 732 B1**
(45) Veröffentlichungstag und Bekanntmachung des Hinweises auf die Patenterteilung: **25.10.2000**
(21) Anmeldenummer: 97114230.2
(22) Anmeldetag: 18.08.1997
(51) Int. Cl.: H01S 5/40, H04B 10/155

(54) **Verfahren und Vorrichtung zur Modulation eines optischen Trägers durch einen Halbleiterverstärker**
Method and Device for modulation of an optical carrier using a semiconductor amplifier
Dispositif et méthode pour modulation d'une porteuse optique utilisant un amplificateur à semi-conducteur

(30) Priorität: 11.11.1996 CH 278296
(43) Veröffentlichungstag der Anmeldung: 13.05.1998
(73) Patentinhaber: Contraves Space AG, 8052 Zürich (CH)
(72) Erfinder: Wandernoth, Bernhard, 9533 Kirchberg (CH)
(74) Vertreter: Hotz, Klaus, Dipl.-El.-Ing./ETH

(56) Entgegenhaltungen:
- EP-A- 0 716 332
- WO-A-90/07141
- LONI A: "OPTICAL MODULATION GOES EXTERNAL" MICROWAVE JOURNAL, Bd. 38, Nr. 2, 1.Februar 1995, Seiten 110, 112, 114, 116-118, XP000504096
- POHLMANN T ET AL: "SCHNELLE OPTISCHE SCHALTER IN LINBO3" NTZ NACHRICHTENTECHNISCHE ZEITSCHRIFT, Bd. 42, Nr. 2, 1.Februar 1989, Seiten 68-71, XP000120846
- EL YUMIN S ET AL: "TAPER-SHAPE DEPENDENCE OF TAPERED-WAVEGUIDE TRAVELING WAVE SEMICONDUCTOR LASER AMPLIFIER (TTW-SLA)" IEICE TRANSACTIONS ON ELECTRONICS, Bd. E77-C, Nr. 4, 1.April 1994, Seiten 624-632, XP000460067
- FUJIWARA M ET AL: "1.55 M LASER DIODE OPTICAL MODULATOR" TRANSACTIONS OF THE INSTITUTE OF ELECTRONICS, INFORMATION AND COMMUNICATION ENGINEERS OF JAPAN, Bd. E71, Nr. 10, Oktober 1988, Seiten 972-974, XP000054344
- H. MEINKE AND F.W. GUNDLACH: TASCHENBUCH DER HOCHFREQUENZTECHNIK, 1968, SPRINGER HEIDELBERG, XP002020460
- G. GROSSKOPF ET AL: "characteristics of semiconductor laser optical amplifier as phase modulator" ELECTRONICS LETTERS, Bd. 25, Nr. 17, 17.August 1989, STEVENAGE GB, Seiten 1188-1189, XP002020461

## Beschreibung

Die vorliegende Erfindung betrifft ein Verfahren und eine Vorrichtung zur Amplituden- oder Phasenmodulation eines optischen Trägers durch einen optischen Halbleiterverstärker, wobei der Modulationsstrom mit den zu übertragenden Daten beaufschlagt wird.

Derartige Verfahren sind beispielsweise aus der PCT-Offenlegungsschrift WO 90 07 141 A und der Veröffentlichung von M. Fujiwara u.a. "1.55 µm Laser Diode Optical Modulator" in Transactions of the Institute of Electronics, Information and Communication Engineers of Japan, Bd. E71, Nr. 10, Okt. 1988. Seiten 972 bis 974 bekannt.

Zudem ist aus der Publikation von El Yumin u.a. "Taped-Shape Dependence of Tapered-Waveguide Traveling Wave Semiconductor Laser Amplifier (TTW-SLA) in IEICE Transactions on Electronics, Bd. E77-C (Japan), Nr. 4, April 1994, Seiten 624 bis 632 ein optischer Halbleiterverstärker bekannt, der als Phasen- oder Amplitudenmodulator verwendet werden soll und eine aktive Zone in Form eines optischen Tapers mit einer als Kapazität wirkenden Elektrodenstruktur aufweist. Dadurch wird eine gute Rausch- und Ausgangsleistungsoptimierung erreicht. Ein Ziel der vorliegenden Erfindung besteht jedoch darin, bei einem optischen Halbleiterverstärker der eingangs erwähnten Art auch eine möglichst hohe Modulationsgrenzfrequenz zu erreichen."

Unter allen Übertragungsverfahren für optische Übertragungssysteme lässt sich mit binärer Phasenmodulation (BPSK) und Homodynempfang (Zwischenfrequenz gleich Null) die grösstmögliche Empfängerempfindlichkeit erzielen. Aus diesem Grund eignet sich dieses Verfahren trotz seiner Komplexität und der hohen Anforderungen an Stabilität und spektraler Reinheit der Laser besonders für Anwendungen, bei denen der Einsatz optischer Verstärker nicht möglich ist und höchste Empfängerempfindlichkeit besonders wichtig ist, wie z.B. in Weitverkehrsnetzen mit Lichtwellenleitern oder für die Intersatellitenkommunikation.

Ein weiteres Standardverfahren zur optischen Phasenmodulation ist die Ausnutzung des linearen elektrooptischen Effektes (Pockels-Effekt) in Elementen aus Lithium Niobat, die entweder als Block (Bulk-Modulator) oder als integriert-optische Wellenleiterbauelemente (integrated Optical Modulator, IOM) ausgeführt sind.
Nachteilig bei diesen Verfahren sind die geringe Modulationsbandbreite sowie der grosse Leistungsbedarf beim Bulk Modulator und die hohen optischen Verluste sowie kleine Obergrenze der optischen Leistung beim Wellenleitermodulator.

Für Freiraumübertragung, z. B. Intersatellitenverbindungen, werden hingegen hohe Bandbreite, hohe optische Leistung, gute Effizienz sowie geringe Treiberleistung gefordert, was mit beiden zuvor angeführten Modulatoranordnungen nicht zu erzielen ist. Die Nachteile der hohen optischen Dämpfung und der geringen Obergrenze für die optische Leistung des ansonsten gut geeigneten Wellenleitermodulators können mit einer Anordnung Sende-Oszillator (Laser) Phasenmodulator-optischer Verstärker umgangen werden.
Hierbei erzeugt der Laser kohärentes Licht mit niedriger optischer Leistung, das nach verlustbehafteter Modulation durch einen quantenoptischen Verstärker auf die nötige Sendeleistung gebracht wird.

Für quantenoptische Verstärker sind im wesentlichen die folgenden drei Prinzipien bekannt:
- Im Faserverstärker wird eine dotierte Faser optisch gepumpt und verstärkt Licht bei einfachem Durchgang.
- Der Bulk-Verstärker ist ein dotiertes Kristall, welches optisch gepumpt wird und Licht bei mehrfachem Durchgang durch dessen gepumpte Zone verstärkt.
- Halbleiterverstärker werden elektrisch gepumpt und verstärken Licht bei einfachem Durchgang durch einen stromdurchflossenen PN-Übergang.

Letztere werden in der faseroptischen Kommunikationstechnik extensiv eingesetzt, unter anderem auch als elektrooptische Schalter nach Mehrfachverzweigungen sowie zur Amplitudenmodulation von frequenzstabilem Licht, da die direkte Amplitudenmodulation des Speisestroms einer Laserdiode neben letzterer auch eine Frequenzmodulation bedingt. In einigen Systemkonfigurationen wird dies zur Datenübertragung durch optische Frequenzumtastung genutzt. Da Laserdioden aus einer optischen Kavität mit spezifischen Resonanzfrequenzen sowie einem Halbleiterverstärker bestehen, kommt dieser Effekt durch die Änderung der Phasengeschwindigkeit des Lichts mit der Injektionsstromdichte im Halbleiterverstärker zustande. Folglich lässt sich bei einfachem Durchgang des Lichts durch einen Halbleiterverstärker mit dem Injektionsstrom eine Phasenverschiebung einstellen. Gleichzeitig muss allerdings mit einer gewissen Amplitudenmodulation gerechnet werden. Solche Verfahren wurden für fasergebundene Kommunikationssysteme entwickelt
( H. Dupont, M. J. Chawki, F. Tillerot, M. Thual, and A. Poudoulec, Measurement of the Effective Phase-Amplitude Coupling Factor alpha eff of High Speed Semiconductor Optical Amplifier Modulator, IEEE PHOTONICS TECHNOLOGY LETTERS. VOL. 6., No. 8. AUGUST 1994, pp. 942;
G. Grosskopf, R. Ludwig, R. Schnabel, H. G. Weber, CHARACTERISTICS OF SEMICONDUCTOR LASER OPTICAL AMPLIFIER AS PHASE MODULATOR, Electronics Letters vol. 25, No. 17, 17. August 1989, pp. 1188 - 1189;
Kun H. No, Richard J. Blackwell, Robert W. Herrick, Joseph L. Levy,
Monolithic Integration of an Amplifier and a Phase Modulator Fabricated in a GRINSCH-SQW Structure by Placing the Junction Below the Quantum Well, IEEE PHOTONICS TECHNOLOGY LETTERS, VOL. 5, NO. 9, pp. 990 - 993, SEPTEMBER 1993;
T.N. Nielsen, U. Gliese, j. Riishoj, K. Stubkjaer, P.Doussiere, P.Garabedian, F. Martin-Leblond, L. Lafragette, D. Leclerc, D. Fernier
1 -Gbit/s QPSK optical microwave transmitter based on a semiconductoroptical-amplifier phase modulator and phase-locked DFB lasers, OFC 94;
J.Riishoj, T. N. Nielsen, und U. Gliese, A 4 Gb/s 2-Level to 2 Gsymbol/s 4-Level Converter GaAs IC for Semiconductor Optical Amplifier QPSK Modulators, IEEE JOURNAL OF SOLID-STATE CIRCUITS, VOL. 29, NO. 10, OCTOBER 1994, p. 1277-1281).

Hierbei wurde in einigen Ausführungen durch segmentierte Strukturen sogar Phasenmodulation erzielt, ohne eine parasitäre Amplitudenmodulation zu erzeugen. Zur Erzielung einer hohen Modulationsbandbreite sollte der eigentliche Halbleiterverstärker geringe Abmessungen aufweisen, was niedrige parasitäre Kapazitäten bedingt und somit hohe Grenzfrequenzen ermöglicht. Bei gegebener Leistungsdichte ergeben sich niedrige Ausgangsleistungen des modulierten Signals, was nicht dem Bedürfnis bei optischer Übertragung im freien Raum entspricht. Vielmehr sollte eine Leistung von etwa einem Watt bei einer Übertragungsrate von 1 Gbit/s zur Verfügung stehen, wobei höhere Datenraten entsprechend mehr optische Leistung erfordern.

Aufgabe der nachfolgend beschriebenen Erfindung ist es daher, die Nachteile des Standes der Technik zu vermeiden und insbesondere durch Phasenmodulation über einen optischen Halbleiterverstärker sowohl hohe optische Signalleistung als auch eine hohe Modulationsrate zu ermöglichen.
Dies wird mit einem Verfahren und einer Vorrichtung nach den kennzeichnenden Merkmalen der Ansprüche 1 und 4 erreicht.

Ansprüche 2, 3, 5-10 stellen Anwendungen der Erfindung dar.

Eine bekannte Methode zur Erzielung hoher Modulationsfrequenzen bei elektrooptischen Lithium-Niobat-Wellenleitermodulatoren ist die Anordnung der Modulationselektroden in Form von parallel zur Ausbreitungsrichtung des Lichts angeordneten Leitungen, auf denen sich das Modulationssignal entlang des Kristalls mit der Gruppengeschwindigkeit des Lichts ausbreitet und mit seinem Feld den Brechungsindex des optischen Wellenleiters beeinflusst. Hierdurch kann die Länge des Modulators die Wellenlänge des modulierenden elektrischen Signals übersteigen.

Hochleistungs-Halbleiterverstärker weisen in ihrer aktiven Zone eine über die Länge an> steigende Breite auf, um die Intensität des Lichts sowie die Injektionsstromdichte mit der über die Länge des Verstärkers steigenden optischen Leistung konstant zu halten. Die Gesamtfläche der Anordnung kann somit als relativ gross angesehen werden, ebenso die Kapazität des PN-Übergangs. Eine über dem zum optischen Wellenleiter kongruenten PN-Übergang angebrachte Elektrode zwecks Zuführung des Speisestroms ist als Streifenleitung ausgeführt.

In Streifenleitungstechnik realisierte Hochfrequenzleitungen lassen sich durch Wellenwiderstand und effektiv wirksame Permittivität charakterisieren (R. K. Hoffmann, Integrierte Mikrowellenschaltungen, Springer, Heidelberg). Bewegt sich die im Verhältnis zur Höhe des Dielektrikums gemessene Breite des Streifenleiters in einem bestimmten Bereich, erfolgt in Abhängigkeit von dieser relativen Breite eine genähert lineare Änderung des Wellenwiderstands der Leitung bei geringer Änderung der relativen Permittivität. Somit weist ein über die Länge in seiner Breite wachsender Streifenleiter ein exponentielles Sinken seines Wellenwiderstandes auf. Gelingt es, die wegen der geringen Änderung der effektiven Permittivität weitgehend konstante Gruppengeschwindigkeit des elektrischen Signals an die des sich unter der Elektrode fortpflanzenden Lichts anzupassen, lässt sich das bereits erwähnte Prinzip der Modulation mittels wandernder Wellen anwenden. Der Streifenleiter verhält sich als Leitung mit exponentiell sich änderndem Wellenwiderstand, wodurch keine Reflexionsstellen entstehen (Meinke, Gundlach, Taschenbuch der Hochfrequenztechnik, Springer, Heidelberg, 1968, Seite 298-S. 304).
Weitere Einzelheiten, Merkmale und Vorteile der Erfindung ergeben sich nicht nur aus den Ansprüchen und diesen zu entnehmenden Merkmalen für sich und/oder in Kombination, sondern auch aus der nachfolgenden Beschreibung eines bevorzugten Ausführungsbeispiels.

Es zeigen:
- Fig. 1: eine Anordnung eines optischen Senders mit Phasenmodulation,
- Fig. 2: eine Anordnung eines optischen Senders mit Halbleiterverstärker als Phasenmodulator,
- Fig. 3: eine Anordnung zur Phasenmodulation mit einem optischem Halbleiterverstärker,
- Fig. 4: einen optischen Halbleiterverstärker nach dem "Tapered Amplifier" Prinzip, und
- Fig. 5: eine Anordnung aus einer Hochfrequenzleitung mit einer angeschalteten inhomogenen Leitung mit reflexionsfreiem Abschluss.

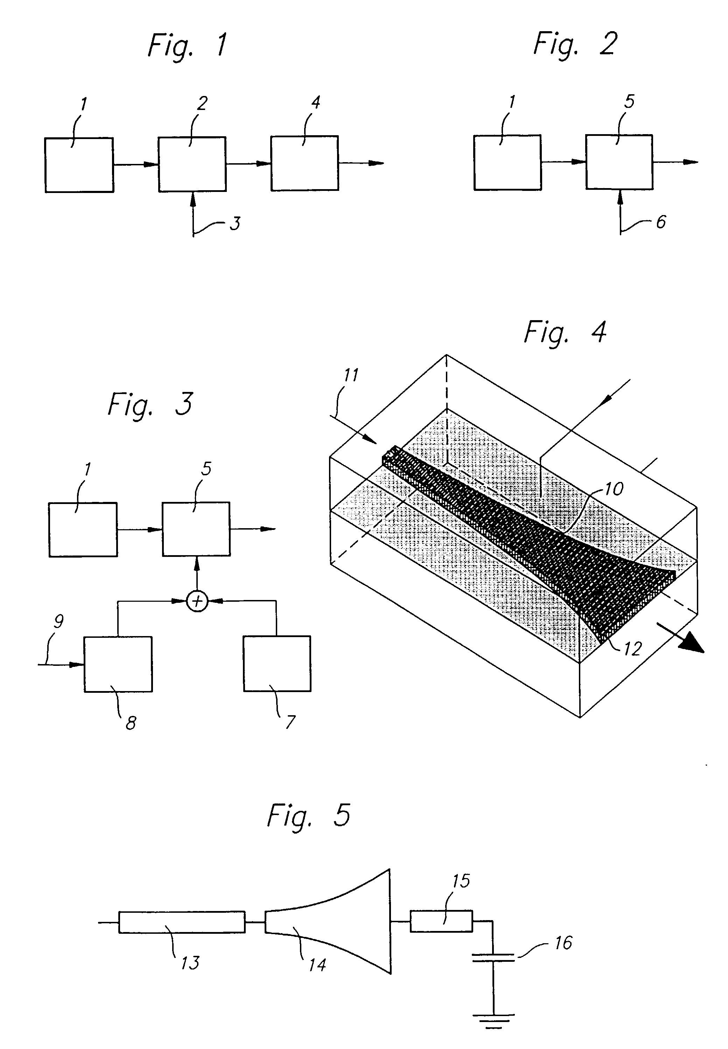

In **Fig. 1** wird ein Prinzip zur Phasenmodulation dargestellt, wie es bei Verwendung von elektrooptischen Wellenleitermodulatoren zur Anwendung kommt. Das Licht aus einem Laser **1** wird in einem Phasenmodulator **2** mittels eines Modulationssignals **3** in seiner Phase moduliert und anschliessend durch einen optischen Verstärker **4** auf die benötigte Leistung angehoben.
In **Fig. 2** wird prinzipiell gezeigt, wie der Phasenmodulator **2** sowie der optische Verstärker **4** aus **Fig. 1** durch einen optischen Halbleiterverstärker **5** ersetzt werden kann. Das Licht des Lasers **1** wird nun im optischen Halbleiterverstärker **5** verstärkt und in der Phase moduliert. Dies geschieht durch die Änderung eines Speisestroms **6** des optischen Halbleiterverstärkers **5**, welcher sich aus dem eigentlichen Betriebsstrom und einem Modulationssignal zusammensetzt.

**Fig. 3** zeigt etwas genauer die Struktur der Anordnung zur Phasenmodulation in Form eines Blockschaltbildes mit dem optischen Halbleiterverstärker **5**. Hierbei wird das Licht des Lasers **1** durch den optischen Halbleiterverstärker **5** moduliert und verstärkt, indem dessen Speisestrom aus einer Gleichstromquelle **7** und einer Modulationsstromquelle **8** addiert wird. Die Modulationsstromquelle **8** wird durch mittels Phasenmodulation des Lichts des Lasers **1** zu übertragende Daten **9** gesteuert.
**Fig. 4** zeigt das Schema eines optischen Halbleiterverstärkers mit einem sich über seine Länge ansteigenden in seiner seitlichen Ausdehnung ändernden optischen Wellenleiter **10**. In einen optischen Eingang **11** geführtes Licht erfährt bis zum optischen Ausgang **12** durch stimulierte Emission von Licht in einem in den optischen Wellenleiter **10** eingefügten, durch elektrischen Strom gepumpten verteilten Halbleiterübergang Verstärkung, wobei sich durch die Änderung der seitlichen Ausdehnung des optischen Wellenleiters **10** eine geringe Änderung der Intensität des verstärkten Lichts gegenüber dem am optischen Eingang **11** vorhandenen ergibt.

Weiterhin fliesst in dem zum optischen Wellenleiter **10** kongruenten Halbleiterübergang der benötigte Speisestrom mit homogener Stromdichte.
In **Fig. 5** ist eine Hochfrequenzleitung **13** dargestellt, deren Wellenwiderstand dem Wellenwiderstand einer mit ihr verbundenen inhomogenen Leitung **14** an der Verbindungsstelle entspricht, um einen breitbandigen, reflexionsfreien Übergang zu gewährleisten. Die inhomogene Leitung ist als Streifenleiter ausgelegt und entspricht in ihrer Form dem optischen Wellenleiter **10** des Halbleiterverstärkers aus **Fig. 4**, und weist einen stetigen Verlauf des Wellenwiderstands über seine Länge auf. Auf diese Weise wird sichergestellt, dass auch sehr hochfrequente Anteile des Modulationsstroms, welcher über die Hochfrequenzleitung **13** zusammen mit dem Gleichstrom zugeführt wird, in den breiteren Bereichen der inhomogenen Leitung **14** keine transversalen Moden erzeugen.
Aufgabe der inhomogenen Leitung **14** ist es, als an den in den optischen Wellenleiter **10** integrierten Halbleiterübergang angefügte Elektrode die gleichmässige Versorgung des Halbleiterübergangs mit Speisestrom zu gewährleisten. Hierbei pflanzt sich der Modulationsstrom in Form einer Wanderwelle parallel mit dem zu modulierenden Licht in Richtung eines Widerstandes **15** fort, der über einen den Gleichstrom abtrennenden Kondensator **16** die inhomogene Leitung **14** reflexionsfrei abschliesst. Die Wanderwelle weist wegen der Struktur der inhomogenen Leitung **14** quer zu ihrer Ausbreitungsrichtung eine gleichmässige Struktur auf, wodurch am optischen Ausgang **12** nach **Fig. 4** keine modulationsbedingten Verzerrungen des Lichts auftreten , die dessen Abstrahlung beeinflussen.

Als Vorteile der beschriebenen Struktur sind der Wegfall des verlustbehafteten Lithium Niobat Wellenleitermodulators und die dadurch bedingte Reduktion der Anzahl der Komponenten zu benennen. Weiterhin wird von der hohen Effizienz der elektro-optischen Energieumwandlung durch Halbleiterverstärker profitiert. Durch die beschriebene Struktur ist es zudem möglich, bei höchsten Modulationsbandbreiten sehr hohe optische Sendeleistungen zu erzielen.

## Patentansprüche

1. Verfahren zur Modulation eines optischen Trägers durch einen optischen Halbleiterverstärker, wobei der Modulationsstrom mit den zu übertragenden Daten beaufschlagt wird, ***dadurch gekennzeichnet, dass*** bei Amplituden- oder Phasenmodulation des Trägers durch den optischen Halbleiterverstärker dessen Speisestrom unter Maximierung der Sendeleistung ausgewählt wird, dass ein aus Gleichstrom und Modulationsstrom bestehender Speisestrom dem Halbleiterverstärker auf einer als Wanderwellenleitung ausgebildeten Elektrode (**10**) zugeführt wird, und dass die Gruppengeschwindigkeit des sich daraus in der Wanderwellenleitung ergebenden elektrischen Signals an die des sich unter der Elektrode fortpflanzenden Lichts angepasst wird.

2. Verfahren nach Anspruch **1**, ***dadurch gekennzeichnet, dass***
die als Wanderwellenleitung ausgebildete Elektrode, über die der optische Halbleiterverstärker den Speisestrom bezieht, für den Modulationsstrom reflexionsfrei abgeschlossen wird.

3. Verfahren nach Anspruch **1** oder **2**, ***dadurch gekennzeichnet, dass***
innerhalb des Halbleiterverstärkers der Speisestrom quer zur Ausbreitungsrichtung des zu verstärkenden Lichts gleichmässig zugeführt wird.

4. Vorrichtung zur Durchführung des Verfahrens nach einem der vorangehenden Ansprüche mit einem an einen Laser (**1**) angeschlossenen Halbleiterverstärker (**5**), dem ein aus einer Gleichstromquelle (**7**) und einer Modulationsstromquelle (**8**) addierter Speisestrom zugeführt wird, ***dadurch gekennzeichnet, dass***
die Modulationsstromquelle (**8**) ausgestaltet ist, um durch Modulation des Laserlichts Daten (**9**) zu übertragen, dass der Halbleiterverstärker (**5**) eine Elektrode (**10**) umfasst, über die der optische Halbleiterverstärker (**5**) den Speisestrom bezieht, dass diese Elektrode (**10**) als Wanderwellenleitung ausgebildet ist, dass Mittel vorhanden sind, um die Gruppengeschwindigkeit des sich in der Wanderwellenleitung ergebenden elektrischen Signals an die des sich unter der Elektrode fortpflanzenden Lichts anzupassen, und dass die als Wanderwellenleitung ausgebildete Elektrode für getaperte optische Halbleiterverstärker als inhomogene Leitung einen für eine reflexionsfreie inhomogene Leitung zulässigen Verlauf des Wellenwiderstands aufweist.

5. Vorrichtung nach Anspruch **4**, ***dadurch gekennzeichnet, dass***
die als Wanderwellenleitung ausgebildete Elektrode (**10**) für ansteigend getaperte optische Halbleiterverstärker als inhomogene Leitung einen für eine ansteigende Leitung zulässigen Verlauf des Wellenwiderstands aufweist.

6. Vorrichtung nach Anspruch **4**, ***dadurch gekennzeichnet, dass***
die als Wanderwellenleitung ausgebildete Elektrode (**10**) ein Streifenleiter in Form einer inhomogen Leitung (**14**) ist.

7. Vorrichtung nach einem der Ansprüche **4** bis **6**, ***dadurch gekennzeichnet, dass***
die als Wanderwellenleitung ausgebildete Elektrode (**10**) durch einen Widerstand (**15**) und einen Kondensator (**16**) abgeschlossen ist.

8. Vorrichtung nach einem der Ansprüche **4** bis **7**, ***dadurch gekennzeichnet, dass***
eine Hochfrequenzleitung (**13**) vorhanden ist, deren Wellenwiderstand dem Wellenwiderstand einer mit ihr verbundenen inhomogenen Leitung (**14**) an der Verbindungsstelle entspricht, und dass die inhomogene Leitung als Streifenleiter ausgelegt ist und in ihrer Form dem optischen Wellenleiter (**10**) des Halbleiterverstärkers entspricht.

9. Vorrichtung nach einem der Ansprüche **4** bis **8, *dadurch gekennzeichnet, dass***
die inhomogene Leitung einen stetigen Verlauf des Wellenwiderstands über seine Länge aufweist.

10. Vorrichtung nach einem der Ansprüche **4** bis **9**, ***dadurch gekennzeichnet, dass***
die inhomogene Leitung (**14**) als an den in den optischen Wellenleiter (**10**) integrierten Halbleiterübergang angefügte Elektrode ausgebildet ist, um eine gleichmässige Versorgung des Halbleiterübergangs mit Speisestrom zu gewährleisten.

## Claims

1. A method for the modulation of an optical carrier by an optical semiconductor amplifier, wherein the modulation current is acted upon by the data to be transmitted, ***characterised in that*** on the amplitude- or phase modulation of the carrier by the optical semiconductor amplifier the supply current to the latter is selected with maximisation of the transmitting power, that a supply current consisting of a direct current and a modulating current is fed to the semiconductor amplifier on an electrode (**10**) formed as a travelling wave guide, and that the group velocity of the electrical signal which results therefrom in the travelling wave guide is matched to that of the light which propagates under the electrode.

2. A method according to claim **1**, ***characterised in that***
the electrode, which is formed as a travelling wave guide and via which the optical semiconductor amplifier draws its supply current, is terminated free from reflections for the modulation current.

3. A method according to claims **1** or **2**, ***characterised in that***
within the semiconductor amplifier the supply current is fed uniformly and transversely to the direction of propagation of the light to be amplified.

4. An apparatus for carrying out the method according to any one of the preceding claims, having a semiconductor amplifier (**5**) which is connected to a laser (**1**) and to which a supply current is fed which is the sum of that from a direct current source (**7**) and that from a modulation current source (**8**), ***characterised in that***
the modulation current source (**8**) is designed for the transmission of data (**9**) by modulation of the laser light, that the semiconductor amplifier (**5**) comprises an electrode (**10**) via which the optical semiconductor amplifier (**5**) draws its supply current, that said electrode (**10**) is formed as a travelling wave guide, that means are provided for matching the group velocity of the electrical signal which results in the travelling wave guide to that of the light which propagates under the electrode, and that the electrode, which is formed as a travelling wave guide for tapered optical semiconductor amplifiers, comprises, as an inhomogeneous line, a progression of the wave impedance which is permissible for a reflection-free, inhomogeneous line.

5. An apparatus according to claim **4**, ***characterised in that*** the electrode (**10**), which is formed as a travelling wave guide for optical semiconductor amplifiers comprising an increasing degree of taper, comprises, as an inhomogeneous line, a progression of the wave impedance which is permissible for an increasing line.

6. An apparatus according to claim **4**, ***characterised in that*** the electrode (**10**), which is formed as a travelling wave guide, is a strip transmission line in the form of an inhomogeneous line (**14**).

7. An apparatus according to any one of claims **4** to **6**, ***characterised in that*** the electrode (**10**) which is formed as a travelling wave guide is terminated by a resistor (**15**) and a capacitor (**16**).

8. An apparatus according to any one of claims **4** to **7**, ***characterised in that*** a highfrequency line (**13**) is provided, the wave impedance of which corresponds to the wave impedance at the connection point of an inhomogeneous line (**14**) which is connected to it, and that the inhomogeneous line is designed as a strip transmission line and its shape corresponds to that of the optical wave guide (**10**) of the semiconductor amplifier.

9. An apparatus according to any one of claims **4** to **8**, ***characterised in that*** the inhomogeneous line comprises a continuous progression of the wave impedance over its length.

10. An apparatus according to any one of claims **4** to **9**, ***characterised in that*** the inhomogeneous line (**14**) is formed as an electrode which is joined to the semiconductor junction integrated in the optical wave guide (**10**), in order to ensure that the semiconductor junction is uniformly fed with supply current.

## Revendications

1. Procédé destiné à la modulation d'une porteuse optique à l'aide d'un amplificateur optique à semi-conducteur, l'alimentation du courant modulateur étant faite par les données à transmettre, **caractérisé en ce que,**
lors de la modulation de l'amplitude ou de la phase de la porteuse par l'amplificateur optique à semi-conducteur, le courant d'alimentation de celui-ci est choisi en optimisant la puissance d'émission, en ce qu'un courant d'alimentation composé d'un courant continu et d'un courant modulateur est amené à l'amplificateur à semi-conducteur sur une électrode (**10**) conçue comme une ligne pour ondes progressives, et en ce que la vitesse de groupe du signal électrique obtenu dans la ligne pour ondes progressives est ajustée à celle de la lumière se propageant sous l'électrode.

2. Procédé selon la revendication **1**, **caractérisé en ce que**
l'électrode conçue comme une ligne pour ondes progressives, et par laquelle l'amplificateur optique à semi-conducteur reçoit le courant d'alimentation, se termine de façon non réfléchissante pour le courant modulateur.

3. Procédé selon la revendication **1** ou **2**, **caractérisé en ce que**
le courant d'alimentation est amené de façon régulière, à l'intérieur de l'amplificateur à semi-conducteur, perpendiculairement à la direction de propagation de la lumière à amplifier.

4. Dispositif permettant de réaliser le procédé selon l'une des revendications précédentes, à l'aide d'un amplificateur à semi-conducteur (**5**) raccordé à un laser (**1**), auquel est amené un courant d'alimentation provenant de l'addition d'une source de courant continu (**7**) et d'une source de courant modulateur (**8**), **caractérisé en ce que** la source de courant modulateur (**8**) est conçue pour transmettre des données (**9**) par modulation de la lumière du laser, en ce que l'amplificateur à semi-conducteur (**5**) comprend une électrode (**10**) par laquelle l'amplificateur optique à semi-conducteur (**5**) reçoit le courant d'alimentation, en ce que cette électrode (**10**) est conçue comme une ligne pour ondes progressives, en ce qu'il existe des moyens pour ajuster la vitesse de groupe du signal électrique obtenu dans la ligne pour ondes progressives à celle de la lumière se propageant sous l'électrode, et en ce que l'électrode conçue comme une ligne pour ondes progressives pour amplificateurs optiques cunéiformes à semi-conducteur présente, en tant que ligne non-homogène, un tracé d'impédance caractéristique admissible pour une ligne non-homogène non réfléchissante.

5. Dispositif selon la revendication **4, caractérisé en ce que**
l'électrode (**10**) conçue comme une ligne pour ondes progressives pour des amplificateurs optiques à semi-conducteur s'élargissant de façon cunéiforme, présente, en tant que ligne non-homogène, un tracé d'impédance caractéristique admissible pour une ligne allant en s'élargissant.

6. Dispositif selon la revendication **4, caractérisé en ce que**
l'électrode (**10**) conçue comme une ligne pour ondes progressives est un guide d'ondes à rubans en forme de ligne non-homogène (**14**).

7. Dispositif selon l'une des revendications **4** à **6, caractérisé en ce que**
l'électrode (**10**) conçue comme une ligne pour ondes progressives se termine par une résistance (**15**) et un condensateur (**16**).

8. Dispositif selon l'une des revendications **4** à **7, caractérisé en ce que**
il existe une ligne à haute fréquence (**13**) dont l'impédance caractéristique correspond, au point de connexion, à l'impédance caractéristique d'une ligne non-homogène (**14**) qui lui est reliée, et en ce que la ligne non-homogène est conçue comme un guide d'ondes à rubans et en ce que sa forme correspond à celle du guide d'ondes optique (**10**) de l'amplificateur à semi-conducteur.

9. Dispositif selon l'une des revendications **4** à **8, caractérisé en ce que**
la ligne non-homogène présente un tracé d'impédance caractéristique constant sur toute sa longueur.

10. Dispositif selon l'une des revendications **4** à **9**, **caractérisé en ce que**
la ligne non-homogène (**14**) est conçue comme une électrode ajoutée à la jonction à semi-conducteur intégrée au guide d'ondes optique (**10**), dans le but de garantir l'alimentation régulière en courant de la jonction à semi-conducteur.
